Europäisches Patentamt

European Patent Office

Office européen des brevets

(19)

(11) Veröffentlichungsnummer : **0 325 981 B1**

(12) # EUROPÄISCHE PATENTSCHRIFT

(45) Veröffentlichungstag der Patentschrift :
**27.05.92 Patentblatt 92/22**

(51) Int. Cl.⁵ : **G01D 5/245, H03M 1/30**

(21) Anmeldenummer : **89100662.9**

(22) Anmeldetag : **16.01.89**

(54) **Schaltungsanordnung mit einem Gebersystem für weg- bzw. winkelabhängige Signale.**

(30) Priorität : **28.01.88 DE 3802549**

(43) Veröffentlichungstag der Anmeldung :
**02.08.89 Patentblatt 89/31**

(45) Bekanntmachung des Hinweises auf die
Patenterteilung :
**27.05.92 Patentblatt 92/22**

(84) Benannte Vertragsstaaten :
**CH DE FR IT LI NL**

(56) Entgegenhaltungen :
**DE-A- 3 126 047**

(56) Entgegenhaltungen :
**FR-A- 2 234 550**
**US-A- 3 675 238**
**US-A- 4 594 540**
**N.T.I.S. TECHNICAL NOTES, Nr. 11, Teil B,**
**Dezember 1984, Seite NTMB4-0999, Spring-**
**field, Virginia, US; J.R. CURRIE et**
**al.:"Circuitry for angle measurements"**

(73) Patentinhaber : **SIEMENS**
**AKTIENGESELLSCHAFT**
**Wittelsbacherplatz 2**
**W-8000 München 2 (DE)**

(72) Erfinder : **Rupp, Jürgen, Dipl.-Ing.**
**Täublingstrasse 26**
**W-8520 Erlangen (DE)**

EP 0 325 981 B1

EP 0 325 981 B1

## Beschreibung

Die Erfindung bezieht sich auf eine Schaltungsanordnung mit einem Gebersystem, das zwei um 90° phasenverschobene weg- bzw. winkelabhängige sinusförmige Signale gleicher Amplitude und Periode liefert, wobei diese zwei Signale jeweils eine Gleichrichtung erfahren und wobei durch eine Verknüpfung der gleichgerichteten Signale miteinander ein vom Weg- bzw. Winkel linear abhängiges digitalisierbares Folgesignal gebildet wird.

Insbesondere zur Erfassung von Rotationsbewegungen von Maschinenteilen sind digitale Inkrementalgeber mit angenähert sinusförmigen Ausgangssignalen, die einen Phasenversatz von 90° aufweisen, handelsüblich. Wenn diese Gebersignale auszuwerten sind, läßt sich eine dazu erforderliche Signalverarbeitung dadurch erleichtern, daß ein linearer Zusammenhang zwischen Weg bzw. Winkel und einem von den Gebersignalen abgeleiteten Folgesignal erreicht wird. Eine Schaltungsanordnung hierzu ist aus der DE-C- 32 18 101 bekannt. Dabei wird aus den Gebersignalen durch Gleichrichtung und Minimalwertbildung ein näherungsweise dreieckförmiges Signal erzeugt, dessen Amplitude einen linearen Zusammenhang zur Position innerhalb einer Achtelperiode des Gebers hat. Durch Analog-Digital-Wandlung und Verknüpfung mit Komparatorsignalen, die die richtige Achtelperiode auswählen, wird die Unterteilung der Geberperiode erreicht.

Eine Schaltungsanordnung der eingangs genannten Art ist aus der US-A-3 675 238 bekannt. Dabei wird aus zwei sinusförmigen Signalen durch eine Gleichrichtung und eine Differenzbildung ein Folgesignal geformt, das einen näherungsweise dreieckförmigen Verlauf aufweist und damit in einer weiteren Auswerteeinrichtung so digitalisierbar ist, daß eine Weg- bzw. Winkelinformation gewonnen werden kann.

Wenn man davon ausgeht, daß sowohl das erste wie auch das zweite sinusförmige Signal mit einer größten Amplitude "1" vorliegt, so ist leicht ersichtlich, daß das resultierende Folgesignal einen Wertebereich von -1 bis +1 dreieckförmig durchläuft. Ein solches sowohl im positiven wie auch im negativen Wertebereich befindliches Folgesignal bedarf allerdings einer relativ aufwendigen Auswertung.

Aufgabe der Erfindung ist, eine Schaltungsanordnung der eingangs genannten Art zu schaffen, bei der mit geringem technischen Aufwand ein leicht auswertbarer linearer Zusammenhang zwischen Weg bzw. Winkel und einem aus den Gebersignalen gewonnen Folgesignal besteht.

Gemäß der Erfindung wird diese Aufgabe dadurch gelöst, daß die Verknüpfung in einem Umsetzer so gebildet wird, daß ein dem Quotienten aus dem Betrag eines der Signale zur Summe der Beträge beider Signale entsprechendes Folgesignal generiert wird.

Es erweist sich dabei als besonders vorteilhaft, daß keine Referenzregelung nötig ist, daß für die Umsetzvorgänge handelsübliche Bausteine, z.B. IR3K06 (SHARP) oder TS 8308 (Thomson), einsetzbar sind, daß die Weg- bzw. Winkelmessung mit hoher Genauigkeit möglich ist, daß Gebersignalfehler, seien es Fehler hinsichtlich der Amplitudengleichheit, Phasen- oder Offset-Fehler das Meßergebnis nur unwesentlich beeinflußen und daß für die Gesamteinrichtung kein besonderer Abgleich er forderlich ist.

Eine erste vorteilhafte Ausbildung der Erfindung ist dadurch gekennzeichnet, daß verbleibende Nichtlinearitäten des resultierenden dreieckförmigen Folgesignals durch eine Signalumsetzung entsprechend einer der Nichtlinearität angepaßten geknickten Kennlinie reduzierbar sind. Dabei kann der an sich schon sehr kleine systembedingte Meßfehler den Erfordernissen entsprechend nochmals reduziert werden.

Eine weitere Ausbildung der Erfindung ist dadurch gekennzeichnet, daß eine Auswerteschaltung vorgesehen ist, durch die entsprechend der Polarität der Signale des Gebersystems die jeweils relevante Viertelperiode bestimmbar ist. Hierdurch ist eine eindeutige Lagebestimmung innerhalb jeweils einer Periode gewährleistet. Eine solche Viertelperiodenbestimmung ist prinzipiell bereits aus der DE-A-3 126 047 bekannt.

Dadurch, daß das resultierende dreieckförmige Folgesignal durch Spiegelung des jeweils auf- bzw. absteigenden Signalzugs in ein sägezahnförmiges Folgesignal umformbar ist, ergibt sich eine ausgesprochen einfache weitere Signalauswertung, da die Signalverläufe in den jeweiligen Viertelperioden von gleicher Form sind.

Ein Ausführungsbeispiel der Erfindung ist in der Zeichnung dargestellt und wird im folgenden näher erläutert. Dabei zeigen:

FIG 1 eine Blockschaltbid und
FIG 2 einige signifikante Signalverläufe.

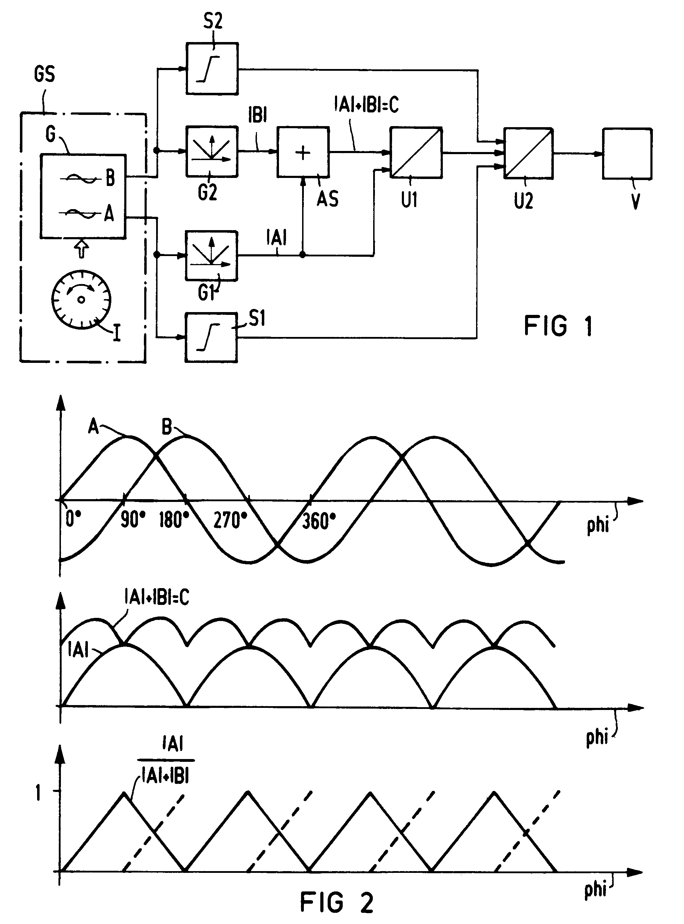

In der Darstellung gemäß FIG 1 ist ein Gebersystem GS zur Aufnahme von Drehbewegungen gezeigt, bei dem eine Impulsscheibe I mechanisch entsprechend der zu erfassenden Drehbewegung bewegt wird und wobei ein Geber G über zwei der Übersichtlichkeit halber nicht dargestellte Aufnahmeköpfe zwei um 90° zueinander phasenverschobene winkelabhängige sinusförmige Signale gleicher Amplitude und Periode entsprechend der Abfolge der Impulsmarken der Impulsscheibe I liefert. Die Signale des Gebers G seinen dabei mit A und B bezeichnet.

Das Signal A wird mit Hilfe eines Gleichrichters G1 gleichgerichtet, an dessen Ausgang demzufolge jeweils

2

ein dem Betrag des Signals A entsprechendes Signal $|A|$ vorliegt. Das Signal B wird einem Gleichrichter G2 zugeführt, der das Signal B ebenfalls in ein dem Betrag des Signals B entsprechendes Ausgangssignal $|B|$ umformt. Die Signale $|A|$ und $|B|$ werden einer Addierstufe AS zugeleitet, die ein der Summe $|A| + |B|$ der Beträge $|A|$ und $|B|$ der Signale A und B entsprechendes Ausgangssignal, im folgenden Signal C genannt, bildet. Dieses Signal C gelangt an den ersten Eingang eines Umsetzers U1, dem als zweites Signal das Signal $|A|$ zugeleitet wird. Im Umsetzer U1 wird der Quotient aus dem Signal $|A|$ und dem Signal $|A| + |B|$ gebildet. Ein diesem Quotienten entsprechendes Signal erweist sich als ein von der Winkelstellung der Impulsscheibe I nahezu linear abhängiges Folgesignal.

Die von der Drehbewegung der Impulsscheibe I abhängigen Signale A und B des Gebers G sind im oberen Diagramm von FIG 2 dargestellt. Bei einer angenommenen Drehrichtung im Uhrzeigersinn folgt dabei das Signal B, das eine gleiche Amplitude und eine gleiche Periode wie das Signal A aufweist, diesem mit einer Verzögerung von 90° Im oberen Diagramm sind außerdem die Grenzen der signifikanten Viertelperioden, d.h. die Werte des Winkels phi von 0°, 90°, 180°, 270° und 360°, bezeichnet.

Im mittleren Diagramm von FIG 2 ist im gleichen Maßstab wie im oberen Diagramm der Betrag des Signals A, d.h. das Signal $|A|$ sowie das Summensignal der Beträge des Signal A und des Signals also das Signal C $= |A| + |B|$ dargestellt.

Im unteren Diagramm von FIG 2 ist gezeigt, daß der Quotient aus dem Signal $|A|$ und dem Signal $|A| + |B|$ auf einen dreiecksförmigen Verlauf hinführt, der durch eine durchgezogene Linie gezeigt ist. Ein solches Signal wird im Umsetzer U1 gemäß FIG 1 erzeugt, wobei dieses Signal im Umsetzer U1 digitalisierbar ist. Zwischen dem zu erfassenden Winkel phi der Impulsscheibe I und dem vom Umsetzer U1 ermittelten Signal $|A|$ : $(|A| + |B|)$ besteht ein linearer Zusammenhang. Damit in möglich einfacher Weise jeder Amplitude dieses Folgesignals ein Winkelwert zugeordnet werden kann, der die jeweilige Lage innerhalb der jeweiligen Viertelperiode anzeigt, wird im Umsetzer U1 jeweils jeder absteigende Signalzug des dreieckförmigen Folgesignals gespiegelt, wie dies in der unteren Darstellung gemäß FIG 2 durch gestrichelte Linien angedeutet ist. Jeder Amplitude des Signals $|A|$ : $(|A| + |B|)$ ist damit eindeutig ein Winkelwert innerhalb einer Viertelperiode zugeordnet. Die Spiegelung kann vorteilhaft auch in einem nachgeschalteten Umsetzer U2 erfolgen, in dem die jeweilige Viertelperiode bekannt ist, so daß dann beispielsweise während jeder zweiten und vierten Viertelperiode gespiegelt wird. Auf die weiteren Funktionen des Umsetzers U2 wird im folgenden noch eingegangen.

Damit aber nicht nur die Lage jeweils innerhalb einer Viertelperiode ermittelt werden kann, sondern damit die Lage innerhalb jeder vollen Periode detektierbar ist, werden die Signale A und B, wie in FIG 1 gezeigt, Schwellwertstufen S1 und S2 zugeleitet, die dann, wenn das Signal A bzw. das Signal B eine positive Polarität aufweist, jeweils ein Kennsignal an den Umsetzer U2 liefern, dem auch das Ausgangssignal des Umsetzers U1 zugeleitet wird. Dann, wenn nur das Signal A eine positive Polarität aufweist, befindet sich das System in der ersten Viertelperiode, dann, wenn sowohl das erste Signal A wie auch das zweite Signal B jeweils eine positive Polarität aufweist, liegt die zweite Viertelperiode vor, dann, wenn nur das Signal B positive Polarität aufweist, liegt die dritte Viertelperiode vor und dann, wenn keines der Signale A und B positive Polarität aufweist, liegt die vierte Viertelperiode vor. Dementsprechend können die vom Umsetzer U1 ermittelten Winkelwerte für die Lage innerhalb der jeweiligen Viertelperiode im Umsetzer U2 additiv um 0°, 90°, 180° bzw. 270° erhöht werden und ein dementsprechendes Ausgangssignal wird vom Umsetzer U2 an nachgeschaltete Verarbeitungseinrichtungen V weitergeleitet.

In der Darstellung gemäß FIG 2 ist im unteren Diagramm das Folgesignal als eine ideale Dreiecks- bzw. Sägezahnfunktion abgebildet. Strenggenommen liegt allerdings eine geringe Nichtlinearität vor, die bei 22,5° bzw. 67,5° einen Fehler von +/-3,86° erzeugt. Dieser Fehler ist für viele Fälle vernachlässigbar, jedoch es ist auch relativ einfach, durch eine geknickte Übertragungskennlinie des Umsetzers U1 eine weitgehende Kompensation vorzunehmen. Günstig erweist sich dabei folgende Dimensionierung.

Der Quotient $|A|$ : $(|A| + |B|)$ sei als Q bezeichnet und stelle das mit dem Fehler +/- 3,68° behaftete Dreieckssignal dar. Dieses wäre dann entsprechend der vorgeschlagenen geknickten Kennlinie folgendermaßen zu einem Signal X zu korrigieren. Bei phi größer 0° und kleiner 22,5° gilt $X = 0,862 \bullet Q$. Bei phi größer 22,5° und kleiner 67,5° gilt $X = 1,19 \bullet Q - 0,095$ und bei phi größer 67,5° und kleiner 90° gilt $X = 0,862 \bullet Q + 0,138$. Bei einer solchen Korrektur beträgt dann der maximale Fehler nur noch 1,6° und kann gegenüber den Phasenfehlern des Gebers G vernachlässigt werden. Der Verlauf von X über Winkel in den anderen Viertelperioden von 90° bis 360° ist analog zum Bereich zwischen 0° und 90° und muß demgemäß nicht getrennt werden.

Sofern Gebersignalfehler auftreten, d.h. Fehler der Amplitudengleichenheit, Phasen- und Offset-Fehler, ergeben sich zwar gegenüber dem Idealfall verschlechterte Meßfehler, jedoch zeigt sich als ein wesentlicher Vorteil, daß der Ausgangscode in jedem Fall vollständig bleibt, d.h. der Verlauf von X reicht immer von 0 bis 1 und die Kurven bleiben monoton. Als Auswirkung der Geberfehler ist lediglich eine lineare Verzerrung zu verzeichnen, die bei der Güte der handelsüblichen Geber innerhalb enger Toleranzen bleibt.

**Patentansprüche**

1. Schaltungsanordnung mit einem Gebersystem, das zwei um 90° phasenverschobene weg- bzw. winkelabhängige sinusförmige Signale (A,B) gleicher Amplitude und Periode liefert, wobei diese zwei Signale jeweils eine Gleichrichtung erfahren und wobei durch eine Verknüpfung der gleichgerichteten Signale miteinander ein vom Weg bzw. Winkel linear abhängiges, in weiteren Auswerteeinrichtungen (U2,V) digitalisierbares Folgesignal gebildet wird, **dadurch gekennzeichnet,** daß die Verknüpfung in einem Umsetzer (U1) so gebildet wird, daß ein dem Quotienten aus dem Betrag ($|A|$ bzw. $|B|$) eines der Signale (A bzw. B) zur Summe ($|A| + |B|$) der Beträge ($|A|$, $|B|$) beider Signale (A,B) entsprechendes Folgesignal generiert wird.

2. Schaltungsanordnung nach Anspruch 1, **dadurch gekennzeichnet,** daß verbleibende Nichtlinearitäten des resultierenden dreieckförmigen Folgesignals durch eine Signalumsetzung entsprechend einer der Nichtlinearität angepaßten geknickte Kennlinie reduzierbar sind.

3. Schaltungsanordnung nach Anspruch 1 oder 2, **dadurch gekennzeichnet,** daß eine Auswerteschaltung (S1, S2,U2) vorgesehen ist, durch die entsprechend der Polarität der Signale (A,B) des Gebersystems (G) die jeweils relevante Viertelperiode bestimmbar ist.

4. Schaltunganordnung nach einem der vorstehenden Ansprüche, **dadurch gekennzeichnet,** daß das resultierende dreieckförmige Folgesignale durch Spiegelung des jeweils auf- bzw. absteigenden Signalzugs in ein sägezahnförmiges Folgesignal umformbar ist.

**Claims**

1. Circuit arrangement with a transmitter system, which supplies two path-dependent or angle-dependent sinusoidal signals (A, B) which are out of phase by 90° and are of the same amplitude and period, whereby these two signals in each case experience a rectification and whereby by means of combination of the rectified signals with one another, a sequence signal is formed which is linearly dependent on the path or angle and which can be digitized in further evaluation devices (U2, V), characterized in that the combination is formed in a converter (U1) in such a way that a sequence signal is generated which corresponds to the ratio of the magnitude ($|A|$ or $|B|$) of one of the signals (A or B) to the sum ($|A| + |B|$) of the magnitudes ($|A|$, $|B|$) of both signals (A,B).

2. Circuit arrangement according to claim 1, characterized in that remaining non-linearities of the resulting triangular sequence signal can be reduced by a signal conversion corresponding to a kinked characteristic curve adapted to the non-linearity.

3. Circuit arrangement according to claim 1 or 2, characterized in that an evaluation circuit (S1,S2,U2) is provided, by means of which, corresponding to the polarity of the signals (A,B) of the transmitter system (G), the respective relevant quarter period can be determined.

4. Circuit arrangement according to one of the above claims, characterized in that the resulting triangular sequence signal can be transformed into a saw-tooth sequence signal by reflection in each case of the ascending or descending signal train.

**Revendications**

1. Montage comportant un système de générateurs, qui délivre deux signaux sinusoïdaux (A,B) de même amplitude et de même période, qui sont déphasés de 90° et sont fonction d'un déplacement ou d'un angle, et dans lequel ces deux signaux sont soumis respectivement à un redressement, et un signal de séquence, qui dépend linéairement du trajet de déplacement ou de l'angle et peut être numérisé dans d'autres dispositifs d'évaluation (u2,v), est formé par combinaison des signaux redressés entre eux, caractérisé par le fait que la combinaison est exécutée dans un convertisseur (U1) de manière à produire un signal de séquence qui correspond au quotient de la valeur absolue ($|A|$ ou $|B|$) de l'un des signaux (A ou B) à la somme ($|A| + |B|$) des valeurs absolues ($|A|$, $|B|$) des deux signaux (A,B).

2. Montage suivant la revendication 1, caractérisé par le fait que des non linéarités subsistantes du signal de séquence triangulaire résultant peuvent être réduites par une conversion des signaux, conformément à une courbe caractéristique coudée, adaptée à la non linéarité.

3. Montage suivant la revendication 1 ou 2, caractérisé par le fait qu'il est prévu un circuit d'évaluation (S1,S2,U2), au moyen duquel le quart de période respectivement important peut être déterminé en fonction de la polarité des signaux (A,B) du système de générateur (G).

4. Montage suivant l'une des revendications précédentes, caractérisé par le fait que les signaux de séquence triangulaires résultants peuvent être convertis, par symétrisation de l'allure respectivement montante ou descendante du signal, en un signal de séquence en dents de scie.

FIG 1

FIG 2